# EUROPEAN PATENT SPECIFICATION

(11) **EP 4 336 808 B1**
(45) Date of publication and mention of the grant of the patent: **08.10.2025**
(21) Application number: 23737851.8
(22) Date of filing: 16.05.2023
(51) Int. Cl.: H04M 1/02, F16C 11/04, G06F 1/16

(54) **FOLDABLE ELECTRONIC DEVICE COMPRISING HINGE STRUCTURE**
KLAPPBARE ELEKTRONISCHE VORRICHTUNG MIT SCHARNIERSTRUKTUR
DISPOSITIF ÉLECTRONIQUE PLIABLE COMPRENANT UNE STRUCTURE DE CHARNIÈRE

(30) Priority: 18.07.2022 KR 20220088188; 30.08.2022 KR 20220109330
(43) Date of publication of application: 13.03.2024
(73) Proprietor: Samsung Electronics Co., Ltd., Suwon-si, Gyeonggi-do 16677 (KR)
(72) Inventor: KIM, Dooryong, Gyeonggi-do 16677 (KR)
(74) Representative: Gulde & Partner
(86) International application number: PCT/KR2023/006575
(87) International publication number: WO 2024/019294

(56) References cited:
- KR-A- 20160 029 538
- KR-A- 20180 030 422
- KR-A- 20200 126 524
- US-A1- 2017 264 723
- US-A1- 2020 033 916

## Description

### [Technical Field]

An embodiment of the disclosure relates to a foldable electronic device including a hinge structure.

### [Background Art]

Owing to the development of information and communication technology and semiconductor technology, various functions are integrated in a single portable electronic device. For example, an electronic device may implement not only a communication function but also an entertainment function such as games, a multimedia function such as music/video playback, a communication and security function such as mobile banking, schedule management, and an electronic wallet function. Such electronic devices are miniaturized so that users may conveniently carry them.

As mobile communication services are extended to the multimedia service area, there is a need to increase the size of a display in an electronic device so that a user may sufficiently use multimedia services as well as voice calls or short messages. However, the size of the display of the electronic device and miniaturization of the electronic device are in a trade-off relationship. In similar regards, publication KR20200126524A relates to a hinge structure for an electronic device, particularly a foldable device, designed to support and manage the rotation of adjacent housing structures using a narrow folding area, publication US2017/264723A1 relates to a display system with a flexible display that includes two main display supports connected by a hinge mechanism and a movement synchronizing coupling, which synchronizes the rotation of the display supports to prevent excessive stress on the display during opening and closing, publication US2020/033916A1 relates to a hinged device with first and second portions that rotate around parallel hinge shafts, synchronized by a tensioned element such as a cord or wire, which ensures that the portions rotate in unison, publication KR20160029538A relates to a flexible display device including a hinge mechanism to enable the folding and unfolding of the display while maintaining the structural integrity and usability of the device across various folding angles, and publication KR20180030422A relates to a two-stage foldable display device including a flexible display panel, designed with both inward and outward folding units, supported by a hinge mechanism and a tension-correcting device.

### [Disclosure]

### [Technical Solution]

According to an embodiment of the disclosure, an electronic device includes a housing including a first housing and a second housing, a flexible display disposed on the first housing and the second housing, and a hinge structure connecting the first housing and the second housing to each other. The hinge structure includes a rotation structure including a rotation bracket, a first rotation member accommodated in the rotation bracket and connected to the first housing, and a second rotation member accommodated in the rotation bracket and connected to the second housing, and an interlocking structure configured to transfer rotational force of the first housing to the second housing. The interlocking structure includes a first pulley shaft rotatably connected to the rotation bracket, a second pulley shaft rotatably connected to the rotation bracket, and a wire connected to the first pulley shaft and the second pulley shaft. The wire is configured to rotate the second pulley shaft based on rotation of the first pulley shaft or rotate the first pulley shaft based on rotation of the second pulley shaft. The interlocking structure further includes an idler pulley located between the first pulley shaft and the second pulley shaft and configured to guide movement of the wire.

According to an embodiment of the disclosure, an electronic device includes a first housing, a second housing, a display disposed on the first housing and the second housing, and a hinge structure connecting the first housing and the second housing to each other. The hinge structure includes a rotation structure including a rotation bracket, a first rotation member configured to rotate while being accommodated in the rotation bracket and connected to the first housing, and a second rotation member configured to rotate while being accommodated in the rotation bracket and connected to the second housing, and an interlocking structure configured to rotate the second housing at an angle substantially equal to an angle at which the first housing rotates. The interlocking structure includes a first pulley shaft rotatably connected to the rotation bracket, and a second pulley shaft rotatably connected to the rotation bracket. The interlocking structure may preferably further include a first arm structure connected to the first pulley shaft and configured to rotate based on rotation of the first rotation member, a second arm structure connected to the second pulley shaft and configured to rotate based on rotation of the second rotation member. The interlocking structure further includes a wire connected to the first pulley shaft and the second pulley shaft.

### [Description of the Drawings]

FIG. 1 is a diagram illustrating an unfolded state of an electronic device according to an embodiment of the disclosure.
FIG. 2 is a diagram illustrating a folded state of an electronic device according to an embodiment of the disclosure.
FIG. 3 is an exploded perspective view illustrating an electronic device according to an embodiment of the disclosure.
FIG. 4 is a perspective view illustrating a hinge structure according to an embodiment of the disclosure.
FIG. 5 is a perspective view illustrating a hinge structure including a rotation bracket and an interlocking structure according to an embodiment of the disclosure.
FIG. 6 is an exploded perspective view illustrating a hinge structure including a rotation bracket and an interlocking structure according to an embodiment of the disclosure.
FIGS. 7A and 7B are diagrams illustrating an electronic device without an idler pulley according to an embodiment of the disclosure.
FIG. 8 is a side view illustrating a hinge structure including a rotation bracket and an interlocking structure according to an embodiment of the disclosure.
FIGS. 9A and 9B are diagrams referred to for describing a relationship between an interlocking structure and a display according to an embodiment of the disclosure.
FIG. 10 is a diagram referred to for describing wire assembly according to an embodiment of the disclosure.
FIG. 11A is a side view illustrating a pulley shaft according to an embodiment of the disclosure. FIG. 11B is a perspective view illustrating a wire-mounted pulley shaft according to an embodiment of the disclosure.
FIG. 12 is a diagram illustrating a wire according to an embodiment of the disclosure.
FIG. 13 is a diagram illustrating an electronic device including a hinge structure and a tension adjustment screw according to an embodiment of the disclosure.
FIG. 14 is a perspective view illustrating a cross-section of the idler pulley according to an embodiment of the disclosure.
FIG. 15A is a perspective view illustrating an idler shaft according to an embodiment of the disclosure.
FIG. 15B is a perspective view illustrating a tension adjustment screw according to an embodiment of the disclosure.
FIG. 15C is a perspective view illustrating a first idler pulley according to an embodiment of the disclosure.

### [Mode for Invention]

An electronic device according to embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. The electronic device according to an embodiment of the disclosure is not limited to those described above.

It should be appreciated that embodiments of the disclosure and the terms used therein are not intended to limit the technological features set forth herein to particular embodiments and include various changes, equivalents, or replacements for a corresponding embodiment, within the scope of the appended claims. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B", "at least one of A and B", "at least one of A or B", "A, B, or C", "at least one of A, B, and C", and "at least one of A, B, or C", may include any one of, or all possible combinations of the items enumerated together in a corresponding one of the phrases. As used herein, such terms as "1^{st}" and "2^{nd}", or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with", "coupled to", "connected with", or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, logic, logic block, part, or circuitry. A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

Since many features of the disclosure are optional only, the features of the preferred embodiments of the disclosure have been described in connection with the term "may". Nevertheless, said preferred embodiments have to be understood as being disclosed in specific preferred combinations as shown in the drawings and therefore features shown in the drawings are to be understood as a real preferred combination for the present invention which however does not restrict the scope of the invention.

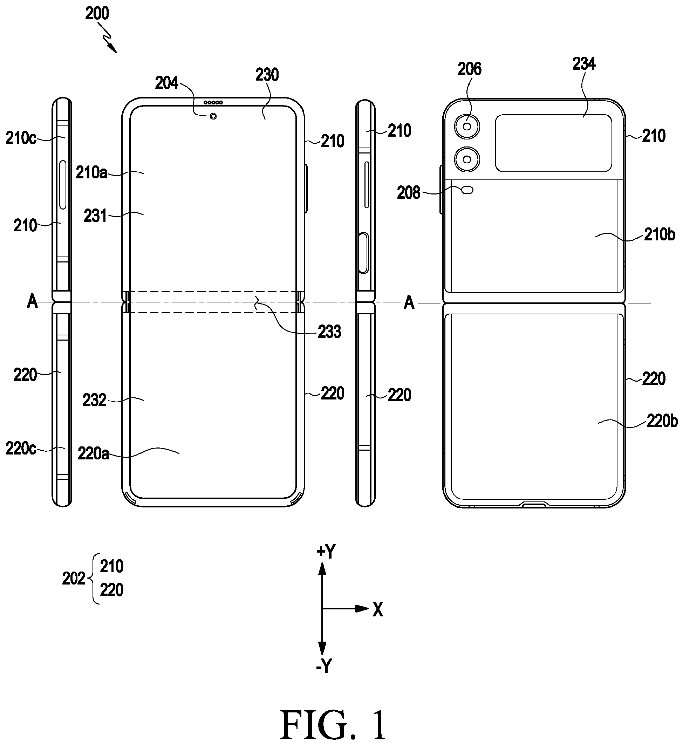

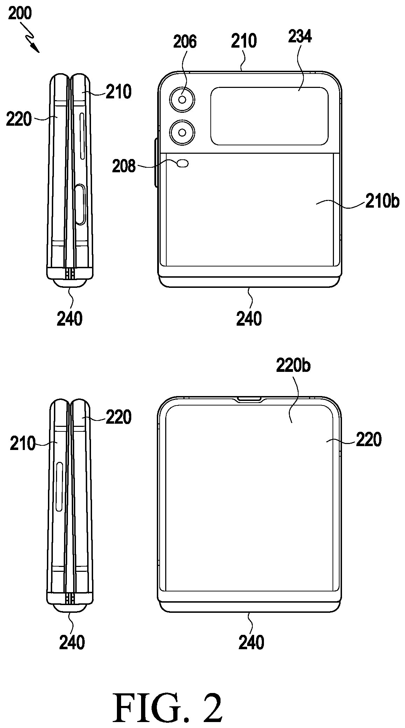

FIG. 1 is a diagram illustrating an unfolded state of an electronic device according to an embodiment of the disclosure. FIG. 2 is a diagram illustrating a folded state of an electronic device according to an embodiment of the disclosure.

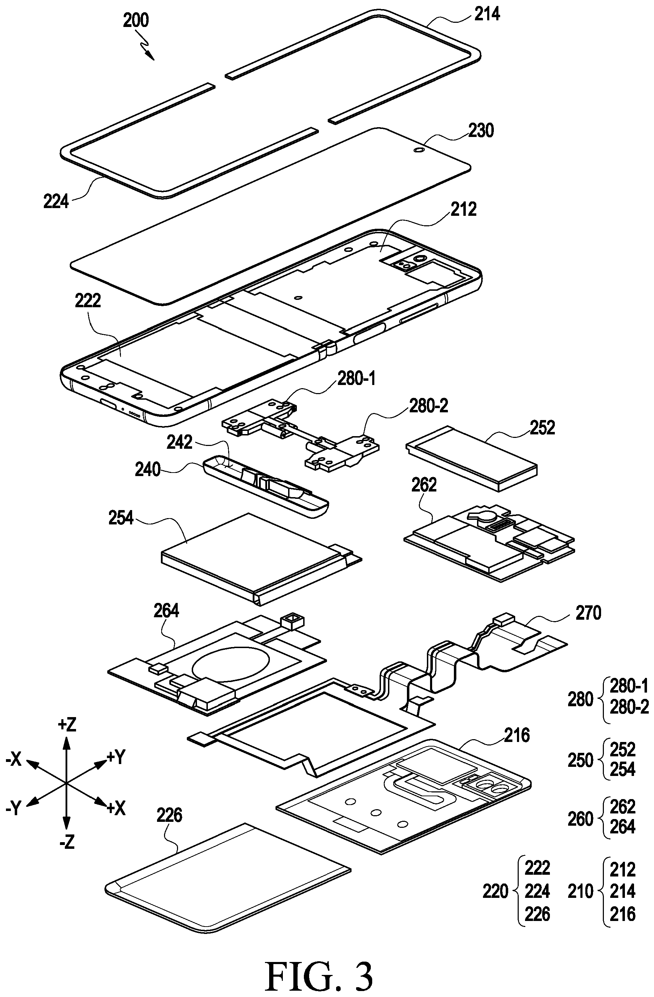

Referring to FIGS. 1 and 2, an electronic device 200 includes a housing 202 to accommodate components (e.g., a battery 250 and/or a printed circuit board 260of FIG. 3) of the electronic device 200 therein, and a flexible display or foldable display 230 (hereinafter, referred to as a display 230) connected to the housing 202. According to an embodiment, the housing 202 may be referred to as a foldable housing.

According to an embodiment, the housing 202 includes a first housing 210 and a second housing 220 configured to rotate relative to the first housing 210.

According to an embodiment, the first housing 210 and/or the second housing 220 may form at least part of the exterior of the electronic device 200. According to an embodiment, a surface on which the display 230 is visually exposed is defined as a front surface (e.g., a first front surface 210a and a second front surface 220a) of the electronic device 200 and/or the housing 202. A surface opposite to the front surface is defined as a rear surface (e.g., a first rear surface 210b and a second rear surface 220b) of the electronic device 200. A surface surrounding at least part of a space between the front and rear surfaces is defined as a side surface (e.g., a first side surface 210c and a second side surface 220c) of the electronic device 200.

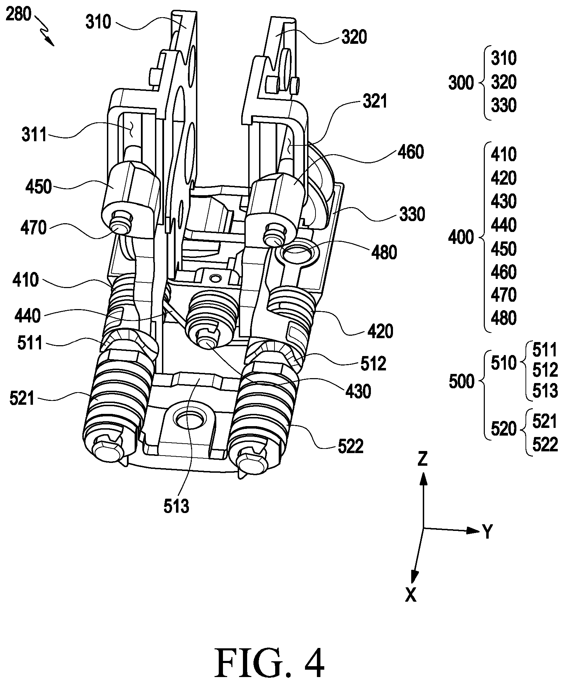

According to an embodiment, the first housing 210 is connected to be rotatable with respect to the second housing 220. For example, the first housing 210 is connected to be rotatable with respect to the second housing 220 using a hinge structure (e.g., a hinge structure 280 of FIG. 3). The electronic device 200 may be changed to the folded state (e.g., FIG. 1) or the unfolded state (e.g., FIG. 2). In the electronic device 200, the first front surface 210a may face the second front surface 220a in the folded state, and the first front surface 210a and the second front surface 220a may face in the same direction in the unfolded state. For example, the first front surface 210a and the second front surface 220a may be located on substantially the same plane in the unfolded state. According to an embodiment, the second housing 220 provides relative movement with respect to the first housing 210. According to an embodiment, the first housing 210 may receive force for rotation with respect to the second housing 202 using an elastic member (e.g., an elastic member 520 of FIG. 4).

According to an embodiment, the first housing 210 and the second housing 220 are disposed on both sides of a folding axis A and symmetrical in shape with respect to the folding axis A as a whole. An angle between the first housing 210 and the second housing 220 may be changed depending on whether the electronic device 200 is in the unfolded state, the folded state, or an intermediate state between the unfolded state and the folded state.

According to an embodiment, the electronic device 200 may include a hinge cover 240. At least part of the hinge cover 240 may be disposed between the first housing 210 and the second housing 220. According to an embodiment, the hinge cover 240 may be covered by parts of the first housing 210 and the second housing 220 or exposed to the outside of the electronic device 200 according to the state of the electronic device 200. According to an embodiment, the hinge cover 240 may protect the hinge structure (e.g., the hinge structure 280 of FIG. 3) and/or the elastic member (e.g., the elastic member 520 of FIG. 4) of the electronic device 200 from external impact. According to an embodiment, the hinge cover 240 may be referred to as a hinge housing.

According to an embodiment, as illustrated in FIG. 1, when the electronic device 200 is in the unfolded state, the hinge cover 240 may be covered by the first housing 210 and the second housing 220 without being exposed. In another example, as illustrated in FIG. 2, when the electronic device 200 is in the folded state (e.g., a fully folded state), the hinge cover 240 may be exposed to the outside from between the first housing 210 and the second housing 220. In another example, in the intermediate state where the first housing 210 and the second housing 220 are folded with a certain angle, the hinge cover 240 may be partially exposed to the outside from between the first housing 210 and the second housing 220. In this case, however, an exposed area may be smaller than in the fully folded state. In an embodiment, the hinge cover 240 may include a curved surface.

According to an embodiment, the display 230 may visually provide information to the outside of the electronic device 200 (e.g., a user). The display 230 may include, for example, a hologram device or a projector and a control circuit for controlling the corresponding device. According to an embodiment, the display 230 may include a touch sensor configured to detect a touch or a pressure sensor configured to measure the strength of force generated by the touch.

According to an embodiment, the display 230 may refer to a display having at least a partial area deformable into a flat or curved surface. For example, the display 230 may be formed to be changed in response to relative movement of the second housing 220 with respect to the first housing 210. According to an embodiment, the display 230 may include a folding area 233, a first display area 231 disposed on one side (e.g., above (+Y direction)) of the folding area 233, and a second display area 232 disposed on the other side (e.g., below (-Y direction)) of the folding area 233. According to an embodiment, the folding area 233 may be located above the hinge structure (e.g., the hinge structure 280 of FIG. 3) and/or the elastic member (e.g., the elastic member 520 of FIG. 4) in the unfolded state (e.g., FIG. 1) of the electronic device 200. For example, at least part of the folding area 233 may face the hinge structure 280. According to an embodiment, the folding area 233 may be referred to as part of the display 230, which is at least partially bent based on a state change (e.g., folded or unfolded) of the electronic device 200. According to an embodiment, the first display area 231 may be disposed on the first housing 210, and the second display area 232 may be disposed on the second housing 220. According to an embodiment, the display 230 may be accommodated in the first housing 210 and the second housing 220.

However, the area division of the display 230 illustrated in FIG. 1 is exemplary, and the display 230 may be divided into a plurality of areas (e.g., four or more or two areas) according to a structure or function. In addition, while the display 230 is divided into areas by the folding area 233 extending in parallel to an X axis or the folding axis A in the embodiment illustrated in FIG. 1, the display 230 may be divided into areas by another folding area (e.g., a folding area parallel to a Y axis) or another folding axis (e.g., a folding axis parallel to the Y axis) in another embodiment. According to an embodiment, the display 230 may be coupled with or disposed adjacent to a touch sensing circuit, a pressure sensor capable of measuring the intensity (pressure) of a touch, and/or a digitizer configured to detect a magnetic field type stylus pen.

According to an embodiment, the electronic device 200 may include a rear display 234. The rear display 234 may face in a direction different from that of the display 230. For example, the display 230 may be visually exposed through the front surface (e.g., the first front surface 210a and/or the second front surface 220a) of the electronic device 200, and the rear display 234 may be visually exposed through the rear surface (e.g., the first rear surface 210b) of the electronic device 200.

According to an embodiment, the electronic device 200 may include at least one camera module 204 and 206 and a flash 208. According to an embodiment, the electronic device 200 may include a front camera module 204 exposed through the front surface (e.g., the first front surface 210a) and/or a rear camera module 206 exposed through the rear surface (e.g., the first rear surface 220b). The camera modules 204 and 206 may include one or more lenses, an image sensor, a flash, and/or an image signal processor. The flash 208 may include a light emitting diode or a xenon lamp. In a certain embodiment, two or more lenses (an infrared camera, a wide-angle lens, and a telephoto lens) and image sensors may be disposed on one surface of the electronic device 200. The front camera module 204 and/or the rear camera module 206 may capture a still image and a video. According to an embodiment, the camera modules 204 and 206 may include one or more lenses, image sensors, image signal processors, or flashes.

FIG. 3 is an exploded perspective view illustrating an electronic device according to an embodiment of the disclosure.

Referring to FIG. 3, the electronic device 200 includes the first housing 210, the second housing 220, the display 230, the hinge cover 240, the battery 250, the printed circuit board 260, a flexible printed circuit board 270, and the hinge structure 280. The configurations of the first housing 210, the second housing 220, the display 230, and the hinge cover 240 of FIGS. 2 and 3 may be wholly or partially identical to those of the first housing 210, the second housing 220, the display 230, and the hinge cover 240 of FIG. 1 and/or FIG. 2.

According to an embodiment, the electronic device 200 may include a first support member 212 and a second support member 222. For example, the first housing 210 may include the first support member 212, and the second housing 220 may include the second support member 222. According to an embodiment, the first support member 212 and/or the second support member 222 may support components (e.g., the display 230, the battery 250, and the printed circuit board 260) of the electronic device 200.

According to an embodiment, the first support member 212 and/or the second support member 222 may be formed of a metal material and/or a non-metal (e.g., polymer) material. According to an embodiment, the first support member 212 may be disposed between the display 230 and the battery 250. For example, the display 230 may be coupled with one surface of the first support member 212, and the battery 250 and the printed circuit board 260 may be disposed on the other surface of the first support member 212.

According to an embodiment, the electronic device 200 may include a first protection member 214 and a second protection member 224. For example, the first housing 210 may include the first protection member 214, and the second housing 220 may include the second protection member 224. According to an embodiment, the protection members 214 and 224 may protect the display 230 from external impact. For example, the first protection member 214 may at least partially surround a part (e.g., the first display area 231 of FIG. 1) of the display 230, and the second protection member 224 may at least partially surround another part (e.g., the second display area 232 of FIG. 1) of the display 230. According to an embodiment, the first protection member 214 may be referred to as a first decoration member, and the second protection member 224 may be referred to as a second decoration member.

According to an embodiment, the housings 210 and 220 may include a first rear plate 216 and a second rear plate 226. For example, the first housing 210 may include the first rear plate 216 connected to the first support member 212, and the second housing 220 may include the second rear plate 226 connected to the second support member 222. According to an embodiment, the rear plates 216 and 226 may form part of the exterior of the electronic device 200. For example, the first rear plate 216 may form the first rear surface (e.g., the first rear surface 210b of FIG. 1), and the second rear plate 226 may form the second rear surface (e.g., the second rear surface 220b of FIG. 1). According to an embodiment, a first battery 252 and a first printed circuit board 262 may be disposed between the first support member 212 and the first rear plate 216, and a second battery 254 and a second printed circuit board 264 may be disposed between the second support member 222 and the second rear plate 226.

According to an embodiment, the hinge cover 240 may accommodate at least part of the hinge structure 280. For example, the hinge cover 240 may include an accommodation groove 242 to accommodate the hinge structure 280 therein. According to an embodiment, the hinge cover 240 may be coupled with the hinge structure 280. According to an embodiment, at least part of the hinge cover 240 may be located between the hinge structure 280 and the housings 210 and 220 in the unfolded state of the electronic device 200. According to an embodiment, the hinge cover 240 may guide movement of the housings 210 and 220. For example, each of the first housing 210 and the second housing 220 may rotate with respect to the hinge cover 240, while being connected to the hinge cover 240.

According to an embodiment, the battery 250, which is a device to supply power to at least one component of the electronic device 200, may include a non-rechargeable primary battery, a rechargeable secondary battery, or a fuel cell. The battery 250 may be integrally disposed inside the electronic device 200 or detachably from the electronic device 200. According to an embodiment, the battery 250 may include the first battery 252 disposed within the first housing 210 and the second battery 254 disposed within the second housing 220. For example, the first battery 252 may be disposed on the first support member 212, and the second battery 254 may be disposed on the second support member 222.

According to an embodiment, a processor, memory, and/or an interface may be mounted on the printed circuit board 260. According to an embodiment, the printed circuit board 260 may include the first printed circuit board 262 disposed within the first housing 210 and the second printed circuit board 264 disposed within the second housing 220.

According to an embodiment, the flexible printed circuit board 270 may electrically connect a component (e.g., the first printed circuit board 262) located in the first housing 210 to a component (e.g., the second printed circuit board 264) located in the second housing 220. According to an embodiment, at least part of the flexible printed circuit board 270 may cross the hinge cover 240 and/or the hinge structure 280. For example, a part of the flexible printed circuit board 270 may be disposed within the first housing 210, and another part thereof may be disposed within the second housing 220. According to an embodiment, the flexible printed circuit board 270 may include a first flexible printed circuit board (not shown) connected to an antenna and a second flexible printed circuit board (not shown) connected to the display 230.

According to an embodiment, the hinge structure 280 may include a plurality of hinge structures 280-1 and 280-2 arranged in parallel. For example, the hinge structure 280 may include a first hinge structure 280-1 and a second hinge structure 280-2 spaced apart from the first hinge structure 280-1. According to an embodiment, the first hinge structure 280-1 may be symmetrical to the second hinge structure 280-2 with respect to a longitudinal direction (e.g., a Y-axis direction) of the electronic device 200.

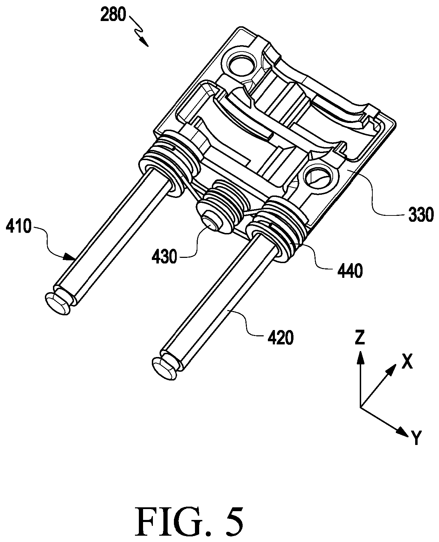

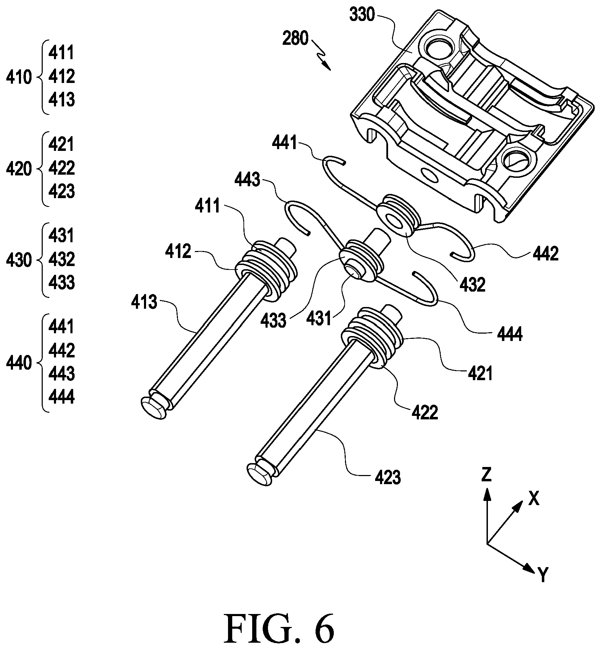

FIG. 4 is a perspective view illustrating a hinge structure according to an embodiment of the disclosure. FIG. 5 is a perspective view illustrating a hinge structure including a rotation bracket and an interlocking structure according to an embodiment of the disclosure. FIG. 6 is an exploded perspective view illustrating a hinge structure including a rotation bracket and an interlocking structure according to an embodiment of the disclosure.

Referring to FIG. 4, the hinge structure 280 includes a rotation structure 300, an interlocking structure 400, and a fixing structure 500. The configuration of the hinge structure 280 of FIG. 4 may be wholly or partially identical to that of the hinge structure 280 of FIG. 3. According to an embodiment, the hinge structure 280 implements a folding motion of an electronic device (e.g., the electronic device 200 of FIG. 2). For example, the hinge structure 280 includes the rotation structure 300, the interlocking structure 400, and/or the fixing structure 500.

According to an embodiment, the rotation structure 300 may substantially implement or guide rotation of the first housing (e.g., the first housing 210 of FIG. 1) and/or the second housing (e.g., the second housing 220 of FIG. 1). According to an embodiment, the rotation structure 300 may provide a first rotation axis and a second rotation axis. According to an embodiment, the rotation structure 300 may be connected to the first support member (e.g., the first support member 212 of FIG. 3) of the housing 210 and the second support member (e.g., the second support member 222 of FIG. 3) of the second housing 220. According to an embodiment, the rotation structure 300 includes a first rotation member 310 connected to the first support member 212 and a second rotation member 320 connected to the second support member 222. According to an embodiment, the rotation structure 300 includes a rotation bracket 330 accommodating the first rotation member 310 and the second rotation member 320. For example, the first rotation member 310 and the second rotation member 320 may rotate with respect to the rotation bracket 330, while being accommodated in the rotation bracket 330.

According to an embodiment, the interlocking structure 400 may interlock rotation of the first housing 210 with rotation of the second housing 220. According to an embodiment, the interlocking structure 400 may transfer at least part of force applied to the first housing 210 to the second housing 220 or transfer at least part of force applied to the second housing 220 to the first housing 210. According to an embodiment, the interlocking structure 400 may preferably include a first arm structure 450 connected to the first rotation member 310 and a second arm structure 460 connected to the second rotation member 320.

According to an embodiment, the interlocking structure 400 includes a wire 440. As a gear is excluded from the hinge structure 280, the production cost of the hinge structure 280 may be reduced, and damage to the hinge structure 280 (e.g., damage to gear teeth) may be prevented. The exclusion of the gear from the hinge structure 280 may reduce or prevent gear backlash and increase the interlocking responsiveness of the hinge structure 280.

According to an embodiment, the fixing structure 500 may position the first housing 210 and the second housing 220 at a certain angle. For example, the fixing structure 500 may provide pressure or force to the rotation structure 300 and/or the interlocking structure 400, so that movement and/or rotation of the first housing 210 and/or the second housing 220 of the electronic device 200 may be prevented or reduced. For example, when the user applies external force equal to or greater than a predetermined value, the hinge structure 200 may allow rotation of the first housing 210 and/or the second housing 220. When no external force is applied or external force less than the predetermined value is applied, the first housing 210 and/or the second housing 220 may be maintained in a stationary state using the fixing structure 500. According to an embodiment, the fixing structure 500 may include at least one spring 521 and 522 and a cam structure 510 to provide force to the rotation structure 300 and/or the interlocking structure 400. According to an embodiment, the stationary state of the first housing 210 and/or the second housing 220 may be referred to as a flex mode of the electronic device 200. Referring to FIG. 4, FIG. 5 and/or FIG. 6, the interlocking structure 400 includes a first pulley shaft 410, a second pulley shaft 420, an idler pulley 430, and the wire 440. The interlocking structure 400 may transfer rotational force of the first housing (e.g., the first housing 210 of FIG. 1) to the second housing (e.g., the second housing 220 of FIG. 1). For example, the interlocking structure 400 may rotate the second housing 220 at an angle substantially equal to an angle at which the first housing 210 rotates.

According to an embodiment, the first pulley shaft 410 and the second pulley shaft 420 are connected to the rotation bracket 330. For example, the first pulley shaft 410 may include a first shaft 413 rotatably connected to the rotation bracket 330. The second pulley shaft 420 may include a second shaft 423 rotatably connected to the rotation bracket 330. According to an embodiment, the first shaft 413 may be disposed substantially parallel to the second shaft 423.

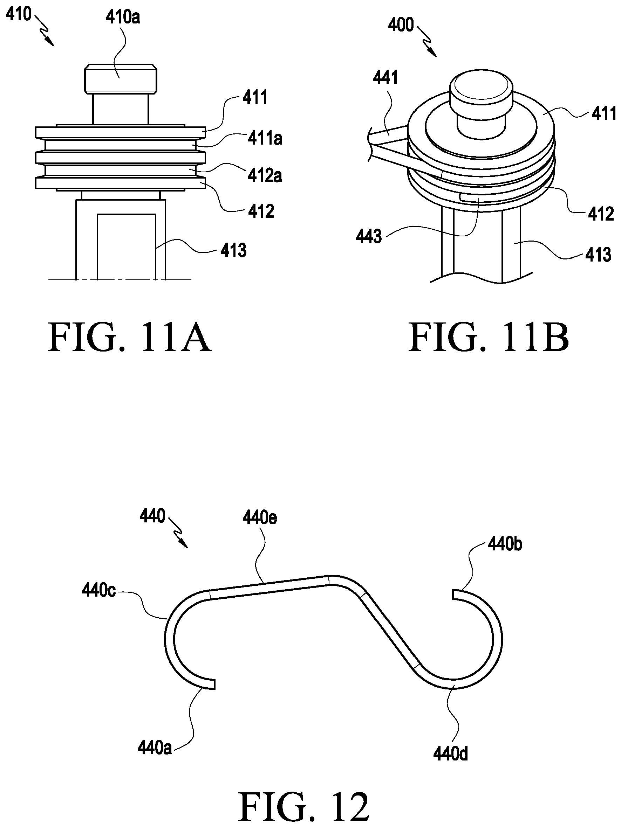

According to an embodiment, the first pulley shaft 410 may include pulleys 411 and 412 to accommodate the wire 440 thereon. For example, the first pulley shaft 410 may include a first pulley 411 and a second pulley 412 installed on or extended from the first shaft 413. According to an embodiment, the first pulley 411 may accommodate a first wire 441 and guide movement of the first wire 441. The second pulley 412 may accommodate a third wire 443 and guide the movement of the third wire 443. The first pulley 411 may be disposed substantially parallel to the second pulley 412. According to an embodiment, the first pulley 411 together with the second pulley 412 may rotate in the same direction as that of the second pulley 412. According to an embodiment, the first pulley 411 and the second pulley 412 may be referred to as a single pulley having two grooves (e.g., a first groove 411a and a second groove 412a of FIG. 11A) formed thereon. According to an embodiment, the first pulley 411 and the second pulley 412 may be referred to as two grooved pulleys each having a groove formed thereon.

According to an embodiment, the second pulley shaft 420 may include pulleys 421 and 422 to accommodate the wire 440 thereon. For example, the second pulley shaft 420 may include a third pulley 421 and a fourth pulley 422 installed or extended from the second shaft 423. According to an embodiment, the third pulley 421 may accommodate a second wire 442 and guide movement of the second wire 442. The fourth pulley 422 may accommodate a fourth wire 444 and guide the movement of the fourth wire 444. The third pulley 421 may be disposed substantially parallel to the fourth pulley 422. The first pulley 411 and the third pulley 421 may be located on substantially the same plane (e.g., a ZY plane). The second pulley 412 and the fourth pulley 422 may be located on substantially the same plane (e.g., the ZY plane). According to an embodiment, the third pulley 421 together with the fourth pulley 422 may rotate in the same direction as that of the fourth pulley 422. According to an embodiment, the third pulley 421 and the fourth pulley 422 may be referred to as a single pulley with two grooves formed thereon. According to an embodiment, the third pulley 421 and the fourth pulley 422 may be referred to as two pulleys each having a groove formed thereon.

According to an embodiment, the first shaft 413 may be connected to a first arm structure 450. For example, when the first rotation member 310 rotates, the first arm structure 450 may receive force from a first pin 470, and rotate together with the first pulley 411, the second pulley 412, and the first shaft 413, while being connected to the first shaft 413.

According to an embodiment, the second shaft 423 may be connected to a second arm structure 460. For example, when the second rotation member 320 rotates, the second arm structure 460 may receive force from a second pin 480, rotate together with the third pulley 421, the fourth pulley 422, and the second shaft 423, while being connected to the second shaft 423. The first arm structure 450 and the second arm structure 460 may not be mandatory components of the electronic device 200 but rather optional.

According to an embodiment, the idler pulley 430 may adjust the tension of the wire 440. For example, in the hinge structure 280 including the idler pulley 430, the length of the wire 440 connected to the pulley (e.g., the first pulley shaft 410, the second pulley shaft 420, and/or the idler pulley 430) may be reduced. As the length of the wire 440 is reduced, the tension of the wire 440 may be increased, and the interlocking responsiveness may be increased. According to an embodiment, the idler pulley 430 is located between the first pulley shaft 410 and the second pulley shaft 420. According to an embodiment, the idler pulley 430 guides the movement of the wire 440. For example, the wire 440 may move along with the idler pulley 430. The idler pulley 430 may not be a mandatory component of the electronic device 200 but rather optional.

According to an embodiment, the idler pulley 430 may include a plurality of pulleys 432 and 433. For example, the idler pulley 430 may include a first idler pulley 432 located between the first pulley 411 and the third pulley 421 and a second idler pulley 433 located between the second pulley 412 and the fourth pulley 422. According to an embodiment, the first idler pulley 432 and the second idler pulley 433 may be rotatably connected to an idler shaft 431. For example, the first idler pulley 432 and the second idler pulley 433 may surround the idler shaft 431. According to an embodiment, the first idler pulley 432 may be disposed parallel to the second idler pulley 433. According to an embodiment, the idler pulley 430 may be referred to as a double idler pulley. According to an embodiment, the first idler pulley 432 may be located between the rotation bracket 330 and the second idler pulley 433.

According to an embodiment, the idler shaft 431 may be connected to the rotation bracket 330. According to an embodiment, the idler shaft 431 may provide a rotation axis around which the first idler pulley 432 and the second idler pulley 433 rotate. The idler shaft 431 may be surrounded by the first idler pulley 432 and the second idler pulley 433.

According to an embodiment, the wire 440 may rotate the second pulley shaft 420 based on the rotation of the first pulley shaft 410 or rotate the first pulley shaft 410 based on the rotation of the second pulley shaft 420. For example, when the first pulley shaft 410 rotates, the second pulley shaft 420 may receive at least part of the rotational force of the first pulley shaft 410 through the wire 440. When the second pulley shaft 420 rotates, the first pulley shaft 410 may receive at least part of the rotational force of the second pulley shaft 420 through the wire 440.

According to an embodiment, the wire 440 may include a plurality of separated wires 441, 442, 443, and 444. According to an embodiment, the wire 440 may include a first wire 441 connected to the first pulley shaft 410 and the first idler pulley 432. The first wire 441 may transfer force to the first pulley 411 or the first idler pulley 432. The wire 440 may include a second wire 442 connected to the second pulley shaft 420 and the first idler pulley 432. The second wire 442 may transfer force to the third pulley 421 or the first idler pulley 432. The wire 440 may include a third wire 443 connected to the first pulley shaft 410 and the second idler pulley 433. The third wire 443 may transmit force to the second pulley 412 or the second idler pulley 433. The wire 440 may include a fourth wire 444 connected to the second pulley shaft 420 and the second idler pulley 433. The fourth wire 444 may transfer force to the fourth pulley 422 or the second idler pulley 433. As the wire 440 includes the plurality of separated wires 441, 442, 443, and 444, the ease of assembly of the wire 440 may be improved.

According to an embodiment, the structure in which the wire 440 includes the plurality of separated wires 441, 442, 443, and 444 may be optional. For example, at least some of the plurality of wires 441, 442, 443, and 444 may be connected or integrated into one wire. According to some embodiments, the first wire 441 and the second wire 442 may be integrated into one wire, and the third wire 443 and the fourth wire 444 may be integrated into one wire.

According to an embodiment, the wire 440 may be made of a metal. For example, the wire 440 may include stainless steel. According to an embodiment, the wire 440 may be a piano steel wire. The material of the wire 440 according to an embodiment is not limited in its type.

According to an embodiment, the wire 440 may have a shape that reduces breakage. For example, the wire 440 may be formed in a structure in which a plurality of wires are twisted (e.g., a winding structure). According to an embodiment, the wire 440 may include a strand including a plurality of wires and a core surrounded by the strand. According to an embodiment, the shape (e.g., the number of turns) of the wire 440 may be changed based on required tensile force.

According to an embodiment, the first arm structure 450 may rotate based on the rotation of the first rotation member 310. According to an embodiment, the first arm structure 450 may be connected to the first pin 470. The first rotation member 310 may include a first slit 311, and the first pin 470 may slide in the first slit 311, while at least part thereof is inserted into the first slit 311. As the first pin 470 slides, an error caused by the difference between a rotation axis of the first rotation member 310 and a rotation axis of the first arm structure 450 may be corrected. According to an embodiment, the first arm structure 450 may be connected to the first pulley shaft 410. For example, when the user folds or unfolds the first housing (e.g., the first housing 210 of FIG. 1), the first pulley shaft 410 may rotate based on the rotation of the first arm structure 450. When the user folds or unfolds the second housing (e.g., the second housing 220 of FIG. 1), the first arm structure 450 may rotate based on the rotation of the first pulley shaft 410.

According to an embodiment, the second arm structure 460 may rotate based on the rotation of the second rotation member 320. According to an embodiment, the second arm structure 460 may be connected to the second pin 480. The second rotation member 320 may include a second slit 312, and the second pin 480 may slide in the second slit 321, while at least part thereof is inserted into the second slit 321. When the second pin 480 slides, an error caused by the difference between a rotation axis of the second rotation member 320 and a rotation axis of the second arm structure 460 may be corrected. According to an embodiment, the second arm structure 460 may be connected to the second pulley shaft 420. For example, when the user folds or unfolds the second housing 220, the second pulley shaft 420 may rotate based on the rotation of the second arm structure 460. When the user folds or unfolds the first housing 210, the second arm structure 460 may rotate based on the rotation of the second pulley shaft 420.

According to an embodiment, the fixing structure 500 may include the cam structure 510. For example, the cam structure 510 may provide pressure to the first pulley shaft 410 and the second pulley shaft 420. According to an embodiment, the cam structure 510 may include a first cam 511 surrounding at least part of the first pulley shaft 410 and formed in the first arm structure 450, a second cam 512 surrounding at least part of the second pulley shaft 420 and formed in the second arm structure 460, and a third cam 513 facing the first cam 511 and the second cam 512. According to an embodiment, a part of the third cam 513 may be located between the first cam 511 and the first spring 521, and another part of the third cam 513 may be located between the second cam 512 and the second spring 522.

According to an embodiment, the fixing structure 500 may include a resilient member 520. The resilient member 520 may provide force (e.g., elastic force) to the cam structure 510 (e.g., the third cam 513). According to an embodiment, the resilient member 520 may include the first spring 521 and the second spring 522 spaced apart from the first spring 521. According to an embodiment, the first spring 521 may surround at least part of the first pulley shaft 410. The second spring 522 may surround at least part of the second pulley shaft 420.

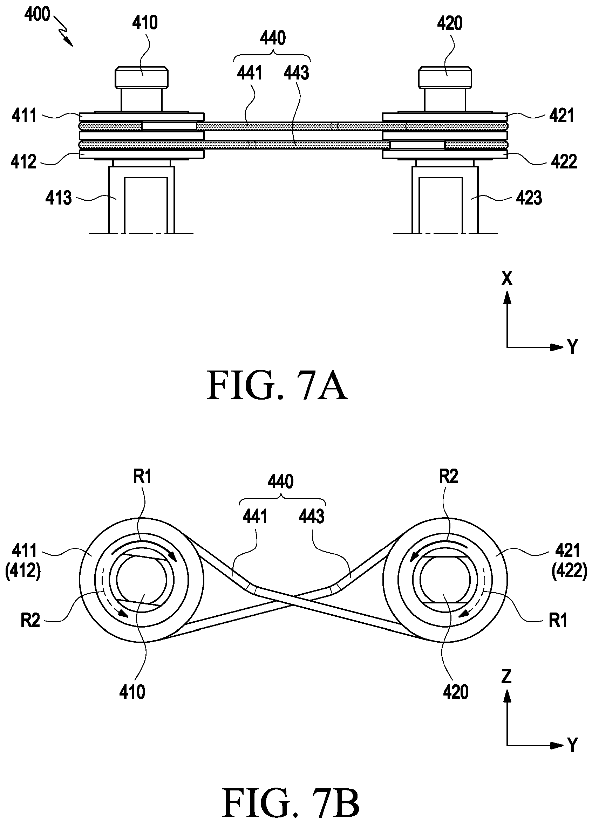

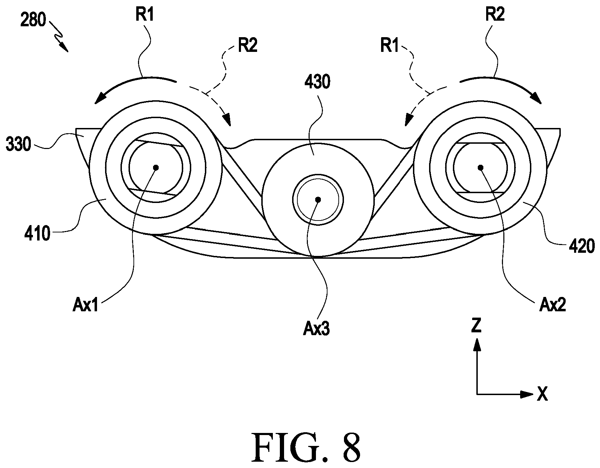

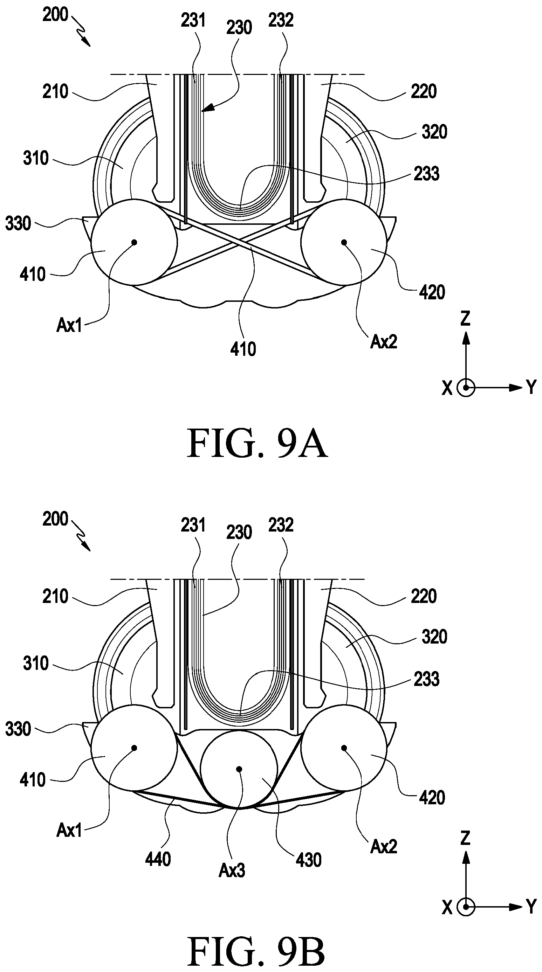

FIGS. 7A and 7B are diagrams illustrating an electronic device without an idler pulley according to an embodiment of the disclosure. FIG. 8 is a side view illustrating a hinge structure including a rotation bracket and an interlocking structure according to an embodiment of the disclosure. FIGS. 9A and 9B are diagrams referred to for describing a relationship between an interlocking structure and a display according to an embodiment of the disclosure.

Referring to FIG. 7A, FIG. 7B, FIG. 8, FIG. 9A, and/or FIG. 9B, the hinge structure 280 may include a rotation structure (e.g., the first rotation member 310, the second rotation member 320, and the rotation bracket 330), the first pulley shaft 410, the second pulley shaft 420, the idler pulley 430, and the wire 440. The configurations of the rotation bracket 330, the first pulley shaft 410, the second pulley shaft 420, the idler pulley 430, and the wire 440 of FIG. 7A, FIG. 7B, FIG. 8, FIG. 9A, and/or FIG. 9B may be wholly or partially identical to those of the rotation bracket 330, the first pulley shaft 410, the second pulley shaft 420, the idler pulley 430, and the wire 440 of FIG. 6.

According to an embodiment, when an electronic device (e.g., the electronic device 200 of FIG. 1) is folded or unfolded, a direction in which the first pulley shaft 410 rotates may be different from a direction in which the second pulley shaft 420 rotates. When the electronic device 200 is unfolded, the first pulley shaft 410 may rotate in a first rotation direction R1, and the second pulley shaft 420 may rotate in a second rotation direction R2. When the electronic device 200 is closed, the first pulley shaft 410 may rotate in the second rotation direction R2, and the second pulley shaft 420 may rotate in the first rotation direction R1. According to an embodiment, the wire 440 may rotate the first pulley shaft 410 based on the rotation of the second pulley shaft 420. When the second pulley shaft 420 rotates, the first pulley shaft 410 may receive at least part of rotational force of the second pulley shaft 420 through the wire 440. According to an embodiment, the wire 440 may rotate the second pulley shaft 420 based on the rotation of the first pulley shaft 410. For example, when the first pulley shaft 410 rotates, the second pulley shaft 420 may receive at least part of rotational force of the first pulley shaft 410 through the wire 440. According to an embodiment, the first rotation direction R1 may be referred to as a counterclockwise direction. The second rotation direction R2 may be referred to as a clockwise direction.

According to an embodiment, the idler pulley 430 may be excluded from the interlocking structure 400. In an embodiment without the idler pulley 430, the wire 440 may include two wires 441 and 443. For example, the wire 440 may include the first wire 441 connected to the first pulley 411 and the third pulley 421, and the third wire 443 connected to the second pulley 412 and the fourth pulley 422.

According to an embodiment, the idler pulley 430 may change the trajectory of the wire 440. For example, the idler pulley 430 may prevent contact between the wire 440 and part (e.g., the folding area 233) of the display 230.

According to an embodiment, the idler pulley 430 may provide a third interlocking axis Ax3 located between a first interlocking axis Ax1 provided by the first pulley shaft 410 and a second interlocking axis Ax2 provided by the second pulley shaft 420. The third interlocking axis Ax3 may be located lower below (a -Z direction) the electronic device (e.g., the electronic device 200 of FIG. 1) and/or the hinge structure 280 than the first interlocking axis Ax1 and/or the second interlocking axis Ax2. For example, when the electronic device 200 is in the unfolded state, the distance between the third interlocking axis Ax3 and the display 230 is greater than the distance between the first interlocking axis Ax1 and the display 230 or the distance between the second interlocking axis Ax2 and the display 230.

The configuration of the hinge structure 280 of FIG. 7A, FIG. 7B, FIG. 8, FIG. 9A, and/or FIG. 9B may be used together with the structure (e.g., the hinge structure 280 of FIGS. 4 to 6) of the foregoing embodiments.

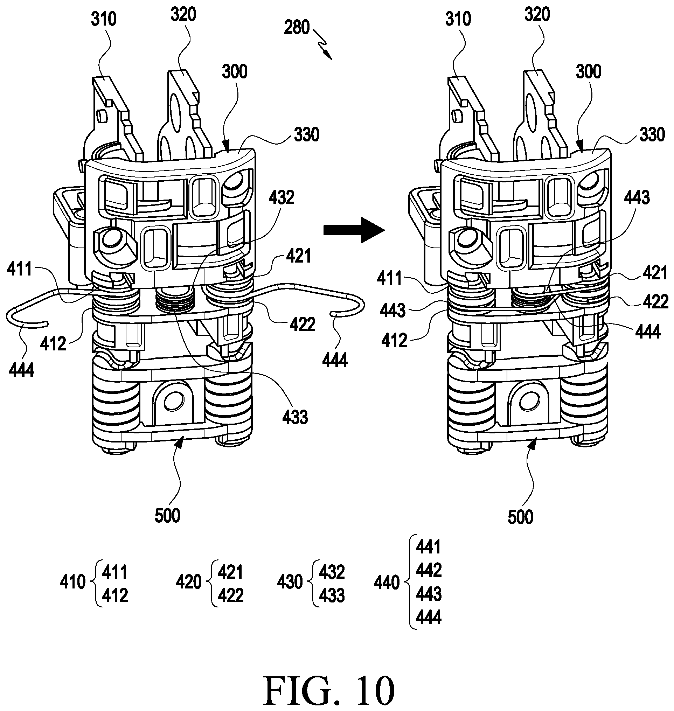

FIG. 10 is a diagram referred to for describing wire assembly according to an embodiment of the disclosure. FIG. 11A is a side view illustrating a pulley shaft according to an embodiment of the disclosure. FIG. 11B is a perspective view illustrating a wire-mounted pulley shaft according to an embodiment of the disclosure. FIG. 12 is a diagram illustrating a wire according to an embodiment of the disclosure.

Referring to FIG. 10, FIG. 11A, FIG. 11B, and/or FIG. 12, the hinge structure 280 may include the rotation structure 300 (e.g., the first rotation member 310, the second rotation member 320, and the rotation bracket 330), the first pulley shaft 410, the second pulley shaft 420, the idler pulley 430, the wire 440, and the fixing structure 500.

The configurations of the rotation structure 300, the first pulley shaft 410, the second pulley shaft 420, the idler pulley 430, the wire 440, and the fixing structure 500 of FIG. 11A, FIG. 11B, and/or FIG. 12 may be wholly or partially identical to those of the rotation structure 300, the first pulley shaft 410, the second pulley shaft 420, the idler pulley 430, the wire 440, and the fixing structure 500 of FIG. 4.

According to an embodiment, the wire 440 may be coupled with the first pulley shaft 410, the second pulley shaft 420, and/or the idler pulley 430. According to an embodiment, the wire 440 may include the plurality of separated wires 441, 442, 443, and 444. Since the wire 440 is provided as the plurality of separated wires 441, 442, 443, and 444, the ease of assembly of the wire 440 may be improved. According to an embodiment, the wire 440 may be bonded to the first pulley shaft 410, the second pulley shaft 420, and/or the idler pulley 430 using a laser. For example, the first wire 441 may be bonded to the first pulley 411 and the first idler pulley 432 using a laser. The second wire 442 may be bonded to the third pulley 421 and the first idler pulley 432 using a laser. The third wire 443 may be bonded to the second pulley 412 and the second idler pulley 433 using a laser. The fourth wire 444 may be bonded to the fourth pulley 422 and the second idler pulley 433 using a laser.

According to an embodiment, the first pulley shaft 410 may accommodate the wire 440. For example, the first pulley 411 of the first pulley shaft 410 may include the first groove 411a to accommodate at least part (e.g., the first wire 441) of the wire 440 therein. The second pulley 412 of the first pulley shaft 410 may include the second groove 412a to accommodate at least part (e.g., the third wire 443) of the wire 440 therein. According to an embodiment, the grooves 411a and 412a may be referred to as recesses or guide rails.

According to an embodiment, the first pulley shaft 410 may include a first shaft end 410a inserted into the rotation bracket 330. The first shaft end 410a may be referred to as part of the shaft 413 extending from the shaft 413. According to an embodiment, the first pulley 411 may be located between the first shaft end 410a and the second pulley 412.

According to an embodiment, the shape of the second pulley shaft 420 may be substantially the same as that of the first pulley shaft 410. For example, the second pulley shaft 420 may include a third groove corresponding to the first groove 411a, a fourth groove corresponding to the second groove 412a, and a second shaft end corresponding to the first shaft end 410a.

According to an embodiment, the wire 440 may have a shape for coupling with a pulley (e.g., the first pulley 411, the second pulley 412, the third pulley 421, the fourth pulley 422, the first idler pulley 432, and/or the second idler pulley 433). For example, at least part of the wire 440 may have a bent shape. According to an embodiment, the wire 440 may include a first end 440a connected to a pulley (e.g., the first pulley 411 or the second pulley 412) of the first pulley shaft 410 or a pulley (e.g., the third pulley 421 or the fourth pulley 422) of the second pulley shaft 420, and a second end 440b connected to a pulley (e.g., the first idler pulley 432 or the second idler pulley 433) of the idler pulley 430.

According to an embodiment, the wire 440 may include a first bent area 440c surrounding at least part of the first pulley 411, the second pulley 412, the third pulley 421, or the fourth pulley 422 and adjacent to the first end 440a, and a second bent area 440d surrounding at least part of the first idler pulley 432 or the second idler pulley 433 and adjacent to the second end 440b. According to an embodiment, at least part of a middle portion 440e of the wire 440 located between the first bent area 440c and the second bent area 440d may have a straight line shape.

According to an embodiment, the shape of the first wire 441 may be substantially the same as that of the second wire 442, the third wire 443, or the fourth wire 444. For example, the first wire 441, the second wire 442, the third wire 443, and/or the fourth wire 444 is replaceable, and the types of components used to manufacture the electronic device (e.g., the electronic device 200 of FIG. 1) may be reduced.

According to an embodiment, the structure of the electronic device 200 described with reference to FIG. 10, FIG. 11A, FIG. 11B and/or FIG. 12 may be used with the foregoing embodiments. For example, the interlocking structure 400 (e.g., the first pulley shaft 410 and/or the wire 400) of FIG. 10, FIG. 11A, FIG. 11B, and/or FIG. 11C may be applied to the hinge structure 280 of FIG. 6, FIG. 7A, and/or FIG. 7B.

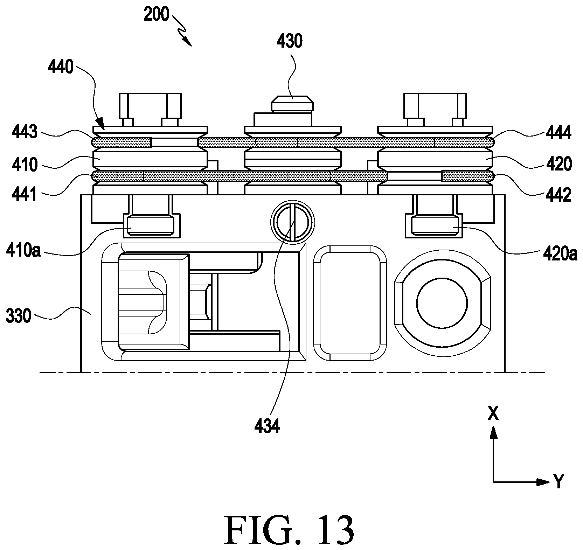

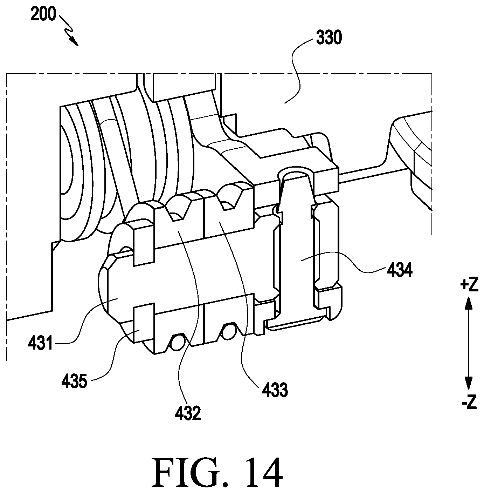

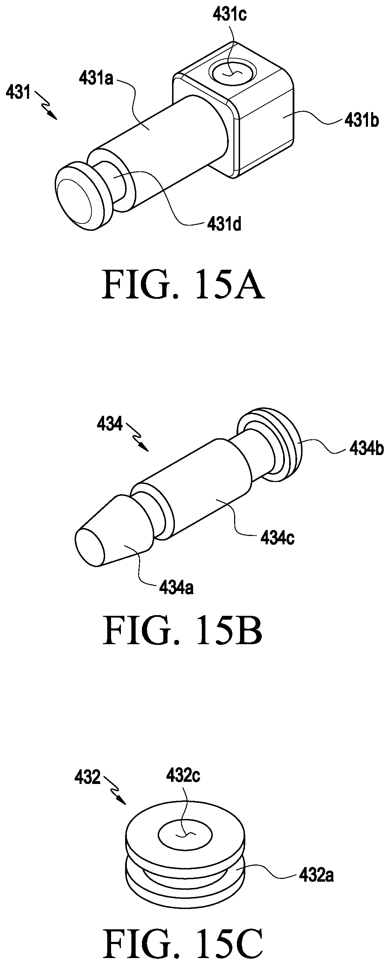

FIG. 13 is a diagram illustrating an electronic device including a hinge structure and a tension adjustment screw according to an embodiment of the disclosure. FIG. 14 is a perspective view illustrating a cross-section of the idler pulley according to an embodiment of the disclosure. FIG. 15A is a perspective view illustrating an idler shaft according to an embodiment of the disclosure. FIG. 15B is a perspective view illustrating a tension adjustment screw according to an embodiment of the disclosure. FIG. 15C is a perspective view illustrating a first idler pulley according to an embodiment of the disclosure.

Referring to FIG. 13, FIG. 14, FIG. 15A, FIG. 15B and/or FIG. 15C, the electronic device 200 may include the rotation bracket 330, the first pulley shaft 410, the second pulley shaft 420, the idler pulley 430, and the wire 440 (e.g., the first wire 441, the second wire 442, the third wire 443, and the fourth wire 444).

The configurations of the rotation bracket 330, the first pulley shaft 410, the second pulley shaft 420, the idler pulley 430, and the wire 440 of FIG. 13, FIG. 14, FIG. 15A, FIG. 15B and/or FIG. 15C may be wholly or partially identical to those of the rotation bracket 330, the first pulley shaft 410, the second pulley shaft 420, the idler pulley 430, and the wire 440 of FIG. 4.

According to an embodiment, the idler shaft 431 may be connected to the rotation bracket 330. For example, the idler shaft 431 may include a body portion 431b disposed within the rotation bracket 330.

According to an embodiment, the idler shaft 431 may accommodate the first idler pulley 432 and the second idler pulley 433. For example, the idler shaft 432 may include a shaft portion 431a extending from the body portion 431b. At least part of the shaft portion 431a may be surrounded by the first idler pulley 432 and the second idler pulley 433.

According to an embodiment, the idler shaft 431 may accommodate a tension adjustment screw 434. For example, the idler shaft 431 may include a screw accommodation hole 431c in which the tension adjustment screw 434 is located. The screw accommodation hole 431c may be a through hole formed in the body portion 431b.

According to an embodiment, the electronic device 200 may include the tension adjustment screw 434 to control the tension of the wire 440. For example, the tension adjustment screw 434 may change the position of at least part of the idler pulley 430. The tension adjustment screw 434 may change the position of the first idler pulley 432 and/or the second idler pulley 433. For example, when the tension adjustment screw 434 rotates while being inserted into the screw accommodation hole 431c of the idler shaft 431, the first idler pulley 432 and the second idler pulley 433 may move up (e.g., +Z direction) or down (e.g., -Z direction) from the electronic device 200. As the first idler pulley 432 and the second idler pulley 433 are moved in a thickness direction of the electronic device 200, the tension of the wire (e.g., the first wire 441, the second wire 442, the third wire 443, and/or the fourth wire 444) may be adjusted (e.g., increased). The increase of the tension of the wire 440 may improve the interlocking responsiveness of the first pulley shaft 410, the second pulley shaft 420, and the idler pulley 430.

According to an embodiment, the tension adjustment screw 434 may connect the idler shaft 431 to the rotation bracket 330. For example, the tension adjustment screw 434 may include an end portion 434a inserted into the rotation bracket 330, a head portion 434b disposed on the rotation bracket 333 and including a groove to insert the screw thereinto, and a screw portion 434c located between the end portion 434a and the head portion 434b and configured to be inserted into the screw accommodation hole 431c. The screw portion 434c may include a screw thread. According to an embodiment, the tension adjustment screw 434 may be a coupling component without a screw thread. For example, the tension adjustment screw 434 may be a rivet.

According to an embodiment, the first idler pulley 432 may include a groove 432a to guide the movement of the wire 440 and a through hole 432c surrounding the shaft portion 431a of the idler shaft 431. The groove 432a may be formed on an outer surface of the first idler pulley 432. The through hole 432c may be formed on an inner surface of the first idler pulley 432.

According to an embodiment, the shape of the second idler pulley 433 may be substantially the same as that of the first idler pulley 432. For example, the second idler pulley 432 may include components corresponding to the groove 432a and the through hole 432c of the first idler pulley 432. Since the first idler pulley 432 has substantially the same shape as the second idler pulley 433, the number of components used for manufacturing the electronic device (e.g., the electronic device 200 of FIG. 1) may be reduced.

According to an embodiment, the electronic device 200 may include a washer 435 to prevent detachment of the first idler pulley 432 and the second idler pulley 433. According to an embodiment, the washer 435 may surround a groove 431d of the idler shaft 431. According to an embodiment, the washer 435 may be referred to as an e-ring.

According to an embodiment, the structure of the electronic device 200 described with reference to FIG. 13, FIG. 14, FIG. 15A, FIG. 15B, and/or FIG. 15C may be used together with the foregoing embodiments. For example, the tension adjustment screw 434, the idler shaft 431, and/or the first idler pulley 432 of FIG. 13, FIG. 14, FIG. 15A, FIG. 15B, and/or FIG. 15C may be used together with the hinge structure 280 of FIG. 4.

An electronic device (e.g., a portable terminal) may include a flat display or a flat and curved display. Due to a fixed display structure, there may be limitations in realizing a screen larger than the electronic device. Therefore, electronic devices including foldable displays are under study.

An electronic device including a foldable display requires an interlocking structure for interlocking between a first housing and a second housing. However, when a gear is used in the interlocking structure, interlocking responsiveness may be reduced due to gear backlash. Moreover, the use of the gear may increase the production cost of the electronic device, and damage to the gear may lead to failure of the electronic device.

According to an embodiment of the disclosure, an electronic device may be provided, including a hinge structure capable of improving interworking between a first housing and a second housing.

According to an embodiment of the disclosure, an electronic device may be provided, including a hinge structure capable of reducing damage to a display.

According to an embodiment of the disclosure, as a gear is excluded from the hinge structure, the production cost of the hinge structure may be reduced, and damage to the hinge structure (e.g., damage to gear teeth) may be prevented. Exclusion of the gear teeth in the hinge structure may reduce or prevent gear backlash and improve the interlocking responsiveness of the hinge structure.

However, the problems to be solved in the disclosure are not limited to the above-mentioned problem, and may be extended in various ways without departing from the scope of the appended claims.

According to an embodiment of the disclosure, an electronic device (e.g., the electronic device 200 of FIG. 1) may include a housing (e.g., the housing 202 of FIG. 1) including a first housing (e.g., the first housing 210 of FIG. 1) and a second housing (e.g., the second housing 220 of FIG. 1), a flexible display (e.g., the display 230 of FIG. 1) disposed on the first housing and the second housing, and a hinge structure (e.g., the hinge structure 280 of FIG. 3) connecting the first housing and the second housing to each other. The hinge structure may include a rotation structure (e.g., the rotation structure 300 of FIG. 4) including a rotation bracket (e.g., the rotation bracket 330 of FIG. 4), a first rotation member (e.g., the first rotation member 310 of FIG. 4) accommodated in the rotation bracket and connected to the first housing, and a second rotation member (e.g., the second rotation member 320 of FIG. 4) accommodated in the rotation bracket and connected to the second housing, and an interlocking structure (e.g., the interlocking structure 400 of FIG. 4) configured to transfer rotational force of the first housing to the second housing. The interlocking structure may include a first pulley shaft (e.g., the first pulley shaft 410 of FIG. 5) rotatably connected to the rotation bracket, a second pulley shaft (e.g., the second pulley shaft 420 of FIG. 5) rotatably connected to the rotation bracket, a wire (e.g., the wire 440 of FIG. 6) connected to the first pulley shaft and the second pulley shaft and configured to rotate the second pulley shaft based on rotation of the first pulley shaft or rotate the first pulley shaft based on rotation of the second pulley shaft, and an idler pulley (e.g., the idle pulley 430 of FIG. 5) located between the first pulley shaft and the second pulley shaft and configured to guide movement of the wire. As the interlocking structure 400 including the wire 400 prevents backlash caused by gear teeth, the interlocking responsiveness may be increased. The interlocking responsiveness may be referred to as the difference between an angle at which the first housing 210 rotates and an angle at which the second housing 220 rotates and/or the difference between a time when the first housing 210 starts rotation and a time when the second housing 220 starts rotation.

According to an embodiment, the idler pulley may include an idler shaft (e.g., the idler shaft 431 of FIG. 6) connected to the rotation bracket, a second idler pulley (e.g., the second idler pulley 433 of FIG. 6) configured to be rotatable with respect to the idler shaft and connected to the wire, and a first idler pulley (e.g., the first idler pulley 432 of FIG. 6) located between the second idler pulley and the rotation bracket, and rotatably connected with respect to the idler shaft.

According to an embodiment, the wire may include a first wire (e.g., the first wire 441 of FIG. 6) connected to the first pulley shaft and the first idler pulley, a second wire (e.g., the second wire 442 of FIG. 6) connected to the second pulley shaft and the first idler pulley, a third wire (e.g., the third wire 443 of FIG. 6) connected to the first pulley shaft and the second idler pulley, and a fourth wire (e.g., the fourth wire 444 of FIG. 6) connected to the second pulley shaft and the second idler pulley. As the wire 440 includes the plurality of separated wires 441, 442, 443, and 444, the difficult of assembly of the hinge structure 280 may be reduced. The inclusion of the plurality of separated wires 441, 442, 443, and 444 in the wire 440 may decrease the length of the single wire 440, thereby increasing the interlocking responsiveness.

According to an embodiment, the first pulley shaft may include a first pulley (e.g., the first pulley 411 of FIG. 6) accommodating the first wire and a second pulley (e.g., the second pulley 412 of FIG. 6) accommodating the third wire and disposed facing the first pulley or substantially parallel to the first pulley. The second pulley shaft may include a third pulley (e.g., the third pulley 421 of FIG. 6) accommodating the second wire, and a fourth pulley (e.g., the fourth pulley 422 of FIG. 6) accommodating the fourth wire and disposed facing the third pulley or substantially parallel to the third pulley.

According to an embodiment, the first pulley shaft may be configured to rotate in a first rotation direction (e.g., the first rotation direction R1 of FIG. 8), and the second pulley shaft may be configured to rotate in a second rotation direction (e.g., the second rotation direction R2 of FIG. 8) opposite to the first rotation direction, when the electronic device is opened. The second pulley shaft may be configured to rotate in the second rotation direction, and the first pulley shaft may be configured to rotate in the first rotation direction, when the electronic device is closed.

According to an embodiment, the first idler pulley and the second idler pulley may be configured to rotate in different directions, when the electronic device is opened or closed.

According to an embodiment, the interlocking structure may include a first arm structure (e.g., the first arm structure 450 of FIG. 4) connected to the first pulley shaft and configured to rotate based on rotation of the first rotation member, and a second arm structure (e.g., the second arm structure 460 of FIG. 5) connected to the second pulley shaft and configured to rotate based on rotation of the second rotation member.

According to an embodiment, the first rotation member may include a first slit (e.g., the first slit 311 of FIG. 4), and the second rotation member may include a second slit (e.g., the second slit 321 of FIG. 4). The interlocking structure may include a first pin (e.g., the first pin 470 of FIG. 4) connected to the first arm structure and configured to slide in the first slit, and a second pin (e.g., the second pin 480 of FIG. 4) connected to the second arm structure and configured to slide in the second slit.

According to an embodiment, the hinge structure may include a fixing structure (500) including a cam structure (510) configured to contact the first pulley shaft and the second pulley shaft and a resilient member (520) configured to provide force (e.g., elastic force) to the cam structure.

According to an embodiment, the resilient member may include a first spring (e.g., the first spring 521 of FIG. 4) surrounding at least part of the first pulley shaft and a second spring (e.g., the second spring 522 of FIG. 4) surrounding at least part of the second pulley shaft.

According to an embodiment, the first pulley shaft may be configured to rotate about a first interlocking axis (e.g., the first interlocking axis Ax1 of FIG. 8), the second pulley shaft may be configured to rotate about a second interlocking axis (e.g., the second interlocking axis Ax2 of FIG. 8), the idler pulley may be configured to rotate about a third interlocking axis (e.g., the third interlocking axis Ax3 of FIG. 8), and when the electronic device is in an unfolded state, a distance between the third interlocking axis and the display may be greater than a distance between the first interlocking axis and the display or a distance between the second interlocking axis and the display.

According to an embodiment, the idler pulley may include a tension adjustment screw (e.g., the tension adjustment screw 434 of FIG. 14) configured to adjust a position of at least part of the idler pulley (e.g., the first idler pulley 432 of FIG. 6 and/or the second idler pulley 433 of FIG. 6) as a tension adjustment screw connecting the idler shaft to the rotation bracket. As the tension adjustment screw 434 adjusts the tension of the wire 440, the interlocking responsiveness of the interlocking structure 400 may be improved.

According to an embodiment, the wire may include a strand including a plurality of wires and a core surrounded by the strand. As the wire is formed as a winding structure including the strand and the core, the durability of the wire may be increased.

According to an embodiment, the wire may include stainless steel.

According to an embodiment, the flexible display may include a first display area (e.g., the first display area 231 of FIG. 9B) connected to the first housing, a second display area (e.g., the second display area 232 of FIG. 9B) connected to the second housing, and a folding area (e.g., the folding area 233 of FIG. 9A) located between the first display area and the second display area. At least part of the folding area may face the idler pulley.

According to an embodiment of the disclosure, an electronic device (e.g., the electronic device 200 of FIG. 1) may include a first housing (e.g., the first housing 210 of FIG. 1), a second housing (e.g., the second housing 220 of FIG. 1), a display (e.g., the display 230 of FIG. 1) disposed on the first housing and the second housing, and a hinge structure (e.g., the hinge structure 280 of FIG. 3) connecting the first housing and the second housing to each other. The hinge structure may include a rotation structure (e.g., the rotation structure 300 of FIG. 4) including a rotation bracket (e.g., the rotation bracket 330 of FIG. 4), a first rotation member (e.g., the first rotation member 310 of FIG. 4) configured to rotate while being accommodated in the rotation bracket and connected to the first housing, and a second rotation member (e.g., the second rotation member 320 of FIG. 4) configured to rotate while being accommodated in the rotation bracket and connected to the second housing, and an interlocking structure (e.g., the interlocking structure 400 of FIG. 4) configured to rotate the second housing at an angle substantially equal to an angle at which the first housing rotates. The interlocking structure may include a first pulley shaft (e.g., the first pulley shaft 410 of FIG. 5) rotatably connected to the rotation bracket, a second pulley shaft (e.g., the second pulley shaft 420 of FIG. 5) rotatably connected to the rotation bracket, a first arm structure (e.g., the first arm structure 450 of FIG. 4) connected to the first pulley shaft and configured to rotate based on rotation of the first rotation member, a second arm structure (e.g., the second arm structure 460 of FIG. 4) connected to the second pulley shaft and configured to rotate based on rotation of the second rotation member, and a wire (e.g., the wire 440 of FIG. 4) connected to the first pulley shaft and the second pulley shaft.

According to an embodiment, the interlocking structure may include an idler pulley (e.g., the idler pulley 430 of FIG. 4) located between the first pulley shaft and the second pulley shaft and configured to guide movement of the wire.

According to an embodiment, the idler pulley may include an idler shaft (e.g., the idler shaft 431 of FIG. 6) connected to the rotation bracket, a second idler pulley (e.g., the second idler pulley 433 of FIG. 6) configured to be rotatable with respect to the idler shaft, and connected to the wire, and a first idler pulley (e.g., the first idler pulley 432 of FIG. 6) located between the second idler pulley and the rotation bracket, and rotatably connected with respect to the idler shaft.

According to an embodiment, the wire may include a first wire (e.g., the first wire 441 of FIG. 6) connected to the first pulley shaft and the first idler pulley, a second wire (e.g., the second wire 442 of FIG. 6) connected to the second pulley shaft and the first idler pulley, a third wire (e.g., the third wire 443 of FIG. 6) connected to the first pulley shaft and the second idler pulley, and a fourth wire (e.g., the fourth wire 444 of FIG. 6) connected to the second pulley shaft and the second idler pulley.

According to an embodiment, the first pulley shaft may be configured to rotate about a first interlocking axis (e.g., the first interlocking axis Ax1 of FIG. 8), the second pulley shaft may be configured to rotate about a second interlocking axis (e.g., the second interlocking axis Ax2 of FIG. 8), the idler pulley may be configured to rotate about a third interlocking axis (e.g., the third interlocking axis Ax3 of FIG. 8). When the electronic device is in an unfolded state, a distance between the third interlocking axis and the display may be greater than a distance between the first interlocking axis and the display or a distance between the second interlocking axis and the display.

## Claims

1. An electronic device (200) comprising:
a housing (202) including a first housing (210) and a second housing (220);
a flexible display (230) disposed on the first housing (210) and the second housing (220); and
a hinge structure (280) connecting the first housing (210) and the second housing (220) to each other,
wherein the hinge structure (280) includes:
a rotation structure (300) including a rotation bracket (330), a first rotation member (310) accommodated in the rotation bracket (330) and connected to the first housing (210), and a second rotation member (320) accommodated in the rotation bracket (330) and connected to the second housing (220), and
an interlocking structure (400) configured to transfer rotational force of the first housing (210) to the second housing (220), and
**characterized in that** the interlocking structure (400) includes:
a first pulley shaft (410) rotatably connected to the rotation bracket (330),
a second pulley shaft (420) rotatably connected to the rotation bracket (330),
a wire (440) connected to the first pulley shaft (410) and the second pulley shaft (420) and configured to rotate the second pulley shaft (420) based on rotation of the first pulley shaft (410) or rotate the first pulley shaft (410) based on rotation of the second pulley shaft (420), and
an idler pulley (430) located between the first pulley shaft (410) and the second pulley shaft (420) and configured to guide movement of the wire (440).

2. The electronic device (200) of claim 1, wherein the idler pulley includes:
an idler shaft (431) connected to the rotation bracket (330),
a second idler pulley (433) configured to be rotatable with respect to the idler shaft (431) and connected to the wire (440), and
a first idler pulley (432) located between the second idler pulley (433) and the rotation bracket (330), and rotatably connected with respect to the idler shaft (431).

3. The electronic device (200) of claim 2, wherein the wire (440) includes:
a first wire (441) connected to the first pulley shaft (410) and the first idler pulley (432),
a second wire (442) connected to the second pulley shaft (420) and the first idler pulley (432),
a third wire (443) connected to the first pulley shaft (410) and the second idler pulley (433), and
a fourth wire (444) connected to the second pulley shaft (420) and the second idler pulley (433).

4. The electronic device (200) of claim 3, wherein the first pulley shaft (410) includes a first pulley (411) accommodating the first wire (441) and a second pulley (412) accommodating the third wire (443) and disposed to face the first pulley (411), and
wherein the second pulley shaft (420) includes a third pulley (421) accommodating the second wire (442), and a fourth pulley (422) accommodating the fourth wire (444) and disposed to face the third pulley (421).

5. The electronic device (200) of any one of claims 2 to 4, wherein the first idler pulley (432) and the second idler pulley (433) are configured to rotate in different directions, when the electronic device (200) is opened or closed.

6. The electronic device (200) of any one of the preceding claims, wherein the first pulley shaft (410) is configured to rotate in a first rotation direction (R1), and the second pulley shaft (420) is configured to rotate in a second rotation direction (R2) opposite to the first rotation direction, when the electronic device (200) is opened, and
wherein the second pulley shaft (420) is configured to rotate in the second rotation direction, and the first pulley shaft (410) is configured to rotate in the first rotation direction, when the electronic device (200) is closed.

7. The electronic device (200) of any one of the preceding claims, wherein the interlocking structure (400) includes:
a first arm structure (450) connected to the first pulley shaft (410) and configured to rotate based on rotation of the first rotation member (310), and
a second arm structure (460) connected to the second pulley shaft (420) and configured to rotate based on rotation of the second rotation member (320).

8. The electronic device (200) of claim 7, wherein the first rotation member (310) includes a first slit (311), and the second rotation member (320) includes a second slit (321), and
wherein the interlocking structure (400) includes:
a first pin (470) connected to the first arm structure (450) and configured to slide in the first slit (311), and
a second pin (480) connected to the second arm structure (460) and configured to slide in the second slit (321).

9. The electronic device (200) of any one of the preceding claims, wherein the hinge structure (280) includes a fixing structure (500) including a cam structure (510) configured to contact the first pulley shaft (410) and the second pulley shaft (420) and a resilient member (520) configured to provide force to the cam structure (510).

10. The electronic device (200) of claim 9, wherein the resilient member (520) includes a first spring (521) surrounding at least part of the first pulley shaft (410) and a second spring (522) surrounding at least part of the second pulley shaft (420).

11. The electronic device (200) of any one of the preceding claims, wherein the first pulley shaft (410) is configured to rotate about a first interlocking axis (Ax1),
wherein the second pulley shaft (420) is configured to rotate about a second interlocking axis (Ax2),
wherein the idler pulley (430) is configured to rotate about a third interlocking axis (Ax3), and
wherein when the electronic device (200) is in an unfolded state, a distance between the third interlocking axis (Ax3) and the flexible display (230) is greater than a distance between the first interlocking axis (Ax1) and the flexible display (230) or a distance between the second interlocking axis (Ax2) and the flexible display (230).

12. The electronic device (200) of any one of the preceding claims, wherein the idler pulley (430) includes a tension adjustment screw (434) configured to adjust a position of at least part of the idler pulley (430) as the tension adjustment screw (434) is connecting the idler shaft (431) to the rotation bracket (330).

13. The electronic device (200) of any one of the preceding claims, wherein the wire (440) includes a strand including a plurality of wires and a core surrounded by the strand.

14. The electronic device (200) of any one of the preceding claims, wherein the wire (440) includes stainless steel.

15. The electronic device (200) of any one of the preceding claims, wherein the flexible display (230) includes a first display area (231) connected to the first housing (210), a second display area (232) connected to the second housing (220), and a folding area (233) located between the first display area (231) and the second display area (232), and
wherein at least part of the folding area (233) faces the idler pulley (430).

## Patentansprüche

1. Elektronische Vorrichtung (200), umfassend:
ein Gehäuse (202), das ein erstes Gehäuse (210) und ein zweites Gehäuse (220) umfasst;
eine flexible Anzeige (230), die auf dem ersten Gehäuse (210) und dem zweiten Gehäuse (220) angeordnet ist; und
eine Scharnierstruktur (280), die das erste Gehäuse (210) und das zweite Gehäuse (220) miteinander verbindet,
wobei die Scharnierstruktur (280) Folgendes beinhaltet:
eine Rotationsstruktur (300), die eine Rotationshalterung (330), ein erstes Rotationselement (310), das in der Rotationshalterung (330) aufgenommen und mit dem ersten Gehäuse (210) verbunden ist, und ein zweites Rotationselement (320) umfasst, das in der Rotationshalterung (330) aufgenommen und mit dem zweiten Gehäuse (220) verbunden ist, und
eine Verriegelungsstruktur (400), die konfiguriert ist, um die Drehkraft des ersten Gehäuses (210) auf das zweite Gehäuse (220) zu übertragen, und
**dadurch gekennzeichnet, dass** die Verriegelungsstruktur (400) Folgendes umfasst:
eine erste Riemenscheibenwelle (410), die drehbar mit der Rotationshalterung (330) verbunden ist,
eine zweite Riemenscheibenwelle (420), die drehbar mit der Rotationshalterung (330) verbunden ist,
einen Draht (440), der mit der ersten Riemenscheibenwelle (410) und der zweiten Riemenscheibenwelle (420) verbunden und konfiguriert ist, um die zweite Riemenscheibenwelle (420) basierend auf der Rotation der ersten Riemenscheibenwelle (410) zu drehen oder die erste Riemenscheibenwelle (410) basierend auf der Rotation der zweiten Riemenscheibenwelle (420) zu drehen, und
eine Umlenkrolle (430), die sich zwischen der ersten Riemenscheibenwelle (410) und der zweiten Riemenscheibenwelle (420) befindet und so konfiguriert ist, dass sie die Bewegung des Drahtes (440) führt.

2. Elektronische Vorrichtung (200) nach Anspruch 1, wobei die Umlenkrolle Folgendes umfasst:
eine Umlenkachse (431), die mit der Rotationshalterung (330) verbunden ist,
eine zweite Umlenkrolle (433), die so konfiguriert ist, dass sie in Bezug auf die Umlenkachse (431) drehbar ist und mit dem Draht (440) verbunden ist, und
eine erste Umlenkrolle (432), die zwischen der zweiten Umlenkrolle (433) und der Rotationshalterung (330) angeordnet und mit der Umlenkachse (431) drehbar verbunden ist.

3. Elektronische Vorrichtung (200) nach Anspruch 2, wobei der Draht (440) Folgendes umfasst:
einen ersten Draht (441), der mit der ersten Riemenscheibenwelle (410) und der ersten Umlenkrolle (432) verbunden ist,
einen zweiten Draht (442), der mit der zweiten Riemenscheibenwelle (420) und der ersten Umlenkrolle (432) verbunden ist,
einen dritten Draht (443), der mit der ersten Riemenscheibenwelle (410) und der zweiten Umlenkrolle (433) verbunden ist, und
einen vierten Draht (444), der mit der zweiten Riemenscheibenwelle (420) und der zweiten Umlenkrolle (433) verbunden ist.

4. Elektronische Vorrichtung (200) nach Anspruch 3, wobei die erste Riemenscheibenwelle (410) eine erste Riemenscheibe (411), die den ersten Draht (441) aufnimmt, und eine zweite Riemenscheibe (412), die den dritten Draht (443) aufnimmt und so angeordnet ist, dass sie der ersten Riemenscheibe (411) zugewandt ist, umfasst, und
wobei die zweite Riemenscheibenwelle (420) eine dritte Riemenscheibe (421) beinhaltet, die den zweiten Draht (442) aufnimmt, und eine vierte Riemenscheibe (422), die den vierten Draht (444) aufnimmt und so angeordnet ist, dass sie der dritten Riemenscheibe (421) zugewandt ist.

5. Elektronische Vorrichtung (200) nach einem der Ansprüche 2 bis 4, wobei die erste Umlenkrolle (432) und die zweite Umlenkrolle (433) so konfiguriert sind, dass sie sich in unterschiedliche Richtungen drehen, wenn die elektronische Vorrichtung (200) geöffnet oder geschlossen wird.

6. Elektronische Vorrichtung (200) nach einem der vorhergehenden Ansprüche, wobei die erste Riemenscheibenwelle (410) so konfiguriert ist, dass sie sich in einer ersten Drehrichtung (R1) dreht, und die zweite Riemenscheibenwelle (420) so konfiguriert ist, dass sie sich in einer zweiten Drehrichtung (R2) entgegengesetzt zur ersten Drehrichtung dreht, wenn die elektronische Vorrichtung (200) geöffnet wird, und
wobei die zweite Riemenscheibenwelle (420) so konfiguriert ist, dass sie sich in der zweiten Drehrichtung dreht, und die erste Riemenscheibenwelle (410) so konfiguriert ist, dass sie sich in der ersten Drehrichtung dreht, wenn die elektronische Vorrichtung (200) geschlossen wird.

7. Elektronische Vorrichtung (200) nach einem der vorhergehenden Ansprüche, wobei die Verriegelungsstruktur (400) Folgendes umfasst:
eine erste Armstruktur (450), die mit der ersten Riemenscheibenwelle (410) verbunden und so konfiguriert ist, dass sie sich basierend auf der Drehung des ersten Rotationselements (310) dreht, und
eine zweite Armstruktur (460), die mit der zweiten Riemenscheibenwelle (420) verbunden und so konfiguriert ist, dass sie sich basierend auf der Drehung des zweiten Rotationselements (320) dreht.

8. Elektronische Vorrichtung (200) nach Anspruch 7, wobei das erste Rotationselement (310) einen ersten Schlitz (311) und das zweite Rotationselement (320) einen zweiten Schlitz (321) aufweist, und
wobei die Verriegelungsstruktur (400) umfasst:
einen ersten Stift (470), der mit der ersten Armstruktur (450) verbunden und konfiguriert ist, um in dem ersten Schlitz (311) zu gleiten, und
einen zweiten Stift (480), der mit der zweiten Armstruktur (460) verbunden und konfiguriert ist, um in dem zweiten Schlitz (321) zu gleiten.

9. Elektronische Vorrichtung (200) nach einem der vorhergehenden Ansprüche, wobei die Scharnierstruktur (280) eine Befestigungsstruktur (500) beinhaltet, die eine Nockenstruktur (510), die so konfiguriert ist, dass sie die erste Riemenscheibenwelle (410) und die zweite Riemenscheibenwelle (420) berührt, und ein elastisches Element (520) beinhaltet, das so konfiguriert ist, dass es eine Kraft auf die Nockenstruktur (510) ausübt.

10. Elektronische Vorrichtung (200) nach Anspruch 9, wobei das elastische Element (520) eine erste Feder (521) beinhaltet, die zumindest einen Teil der ersten Riemenscheibenwelle (410) umgibt, und eine zweite Feder (522), die zumindest einen Teil der zweiten Riemenscheibenwelle (420) umgibt.

11. Elektronische Vorrichtung (200) nach einem der vorhergehenden Ansprüche, wobei die erste Riemenscheibenwelle (410) so konfiguriert ist, dass sie sich um eine erste Verriegelungsachse (Ax1) dreht,
wobei die zweite Riemenscheibenwelle (420) so konfiguriert ist, dass sie sich um eine zweite Verriegelungsachse (Ax2) dreht,
wobei die Umlenkrolle (430) so konfiguriert ist, dass sie sich um eine dritte Verriegelungsachse (Ax3) dreht, und
wobei, wenn sich die elektronische Vorrichtung (200) in einem ausgeklappten Zustand befindet, ein Abstand zwischen der dritten Verriegelungsachse (Ax3) und der flexiblen Anzeige (230) größer ist als ein Abstand zwischen der ersten Verriegelungsachse (Ax1) und der flexiblen Anzeige (230) oder ein Abstand zwischen der zweiten Verriegelungsachse (Ax2) und der flexiblen Anzeige (230).

12. Elektronische Vorrichtung (200) nach einem der vorhergehenden Ansprüche, wobei die Umlenkrolle (430) eine Spannungseinstellschraube (434) beinhaltet, die konfiguriert ist, um eine Position von zumindest einem Teil der Umlenkrolle (430) einzustellen, wenn die Spannungseinstellschraube (434) die Umlenkwelle (431) mit der Rotationshalterung (330) verbindet.

13. Elektronische Vorrichtung (200) nach einem der vorhergehenden Ansprüche, wobei der Draht (440) eine Litze umfasst, die eine Vielzahl von Drähten und einen von der Litze umgebenen Kern beinhaltet.

14. Elektronische Vorrichtung (200) nach einem der vorhergehenden Ansprüche, wobei der Draht (440) rostfreien Stahl beinhaltet.

15. Elektronische Vorrichtung (200) nach einem der vorhergehenden Ansprüche, wobei die flexible Anzeige (230) einen ersten Anzeigebereich (231), der mit dem ersten Gehäuse (210) verbunden ist, einen zweiten Anzeigebereich (232), der mit dem zweiten Gehäuse (220) verbunden ist, und einen Faltbereich (233) umfasst, der sich zwischen dem ersten Anzeigebereich (231) und dem zweiten Anzeigebereich (232) befindet, und
wobei zumindest ein Teil des Faltbereichs (233) der Umlenkrolle (430) zugewandt ist.

## Revendications

1. Dispositif électronique (200), comprenant :
un boîtier (202) comprenant un premier boîtier (210) et un deuxième boîtier (220) ;
un affichage flexible (230) disposé sur le premier boîtier (210) et le deuxième boîtier (220) ; et
une structure de charnière (280) reliant le premier boîtier (210) et le deuxième boîtier (220) l'un à l'autre,
dans lequel la structure de charnière (280) comprend :
une structure de rotation (300) comprenant un support de rotation (330), un premier élément de rotation (310) logé dans le support de rotation (330) et relié au premier boîtier (210), et un second élément de rotation (320) logé dans le support de rotation (330) et relié au second boîtier (220), et
une structure de verrouillage (400) configurée pour transférer la force de rotation du premier boîtier (210) au second boîtier (220), et
**caractérisé en ce que** la structure de verrouillage (400) comprend :
un premier arbre de poulie (410) relié de manière rotative au support de rotation (330),
un deuxième arbre à poulie (420) relié de manière rotative au support de rotation (330),
un fil (440) relié au premier arbre de poulie (410) et au second arbre de poulie (420) et configuré pour faire tourner le second arbre de poulie (420) en fonction de la rotation du premier arbre de poulie (410) ou pour faire tourner le premier arbre de poulie (410) en fonction de la rotation du second arbre de poulie (420), et
une poulie de renvoi (430) située entre le premier arbre de poulie (410) et le second arbre de poulie (420) et configurée pour guider le mouvement du fil (440).

2. Dispositif électronique (200) de la revendication 1, dans lequel la poulie de renvoi comprend :
un arbre de renvoi (431) relié au support de rotation (330),
une seconde poulie de renvoi (433) configurée pour être rotative par rapport à l'arbre de renvoi (431) et reliée au fil (440), et
une première poulie de renvoi (432) située entre la seconde poulie de renvoi (433) et le support de rotation (330), et reliée de manière rotative par rapport à l'arbre de renvoi (431).

3. Dispositif électronique (200) de la revendication 2, dans lequel le fil (440) comprend :
un premier fil (441) relié au premier arbre de poulie (410) et à la première poulie de renvoi (432),
un second fil (442) relié au second arbre de poulie (420) et à la première poulie de renvoi (432),
un troisième fil (443) relié au premier arbre de poulie (410) et à la seconde poulie de renvoi (433), et
un quatrième fil (444) relié au second arbre de poulie (420) et à la seconde poulie de renvoi (433).

4. Dispositif électronique (200) de la revendication 3, dans lequel le premier arbre de poulie (410) comprend une première poulie (411) accueillant le premier fil (441) et une seconde poulie (412) accueillant le troisième fil (443) et disposée pour faire face à la première poulie (411), et
dans lequel le deuxième arbre de poulie (420) comprend une troisième poulie (421) accueillant le second fil (442), et une quatrième poulie (422) accueillant le quatrième fil (444) et disposée pour faire face à la troisième poulie (421).

5. Dispositif électronique (200) de l'une quelconque des revendications 2 à 4, dans lequel la première poulie de renvoi (432) et la seconde poulie de renvoi (433) sont configurées pour tourner dans des directions différentes, lorsque le dispositif électronique (200) est ouvert ou fermé.

6. Dispositif électronique (200) de l'une quelconque des revendications précédentes, dans lequel le premier arbre de poulie (410) est configuré pour tourner dans un premier sens de rotation (R1), et le second arbre de poulie (420) est configuré pour tourner dans un second sens de rotation (R2) opposé au premier sens de rotation, lorsque le dispositif électronique (200) est ouvert, et
dans lequel le second arbre de poulie (420) est configuré pour tourner dans le second sens de rotation, et le premier arbre de poulie (410) est configuré pour tourner dans le premier sens de rotation, lorsque le dispositif électronique (200) est fermé.

7. Dispositif électronique (200) de l'une quelconque des revendications précédentes, dans lequel la structure de verrouillage (400) comprend :
une première structure de bras (450) reliée au premier arbre de poulie (410) et configurée pour tourner en se basant sur la rotation du premier élément de rotation (310), et
une seconde structure de bras (460) reliée au second arbre de poulie (420) et configurée pour tourner en se basant sur la rotation du second élément de rotation (320).

8. Dispositif électronique (200) de la revendication 7, dans lequel le premier élément de rotation (310) comprend une première fente (311) et le deuxième élément de rotation (320) comprend une deuxième fente (321), et
dans lequel la structure de verrouillage (400) comprend :
une première broche (470) reliée à la première structure de bras (450) et configurée pour coulisser dans la première fente (311), et
une seconde broche (480) reliée à la seconde structure de bras (460) et configurée pour coulisser dans la seconde fente (321).

9. Dispositif électronique (200) de l'une quelconque des revendications précédentes, dans lequel la structure de charnière (280) comprend une structure de fixation (500) comprenant une structure de came (510) configurée pour entrer en contact avec le premier arbre de poulie (410) et le second arbre de poulie (420) et un élément élastique (520) configuré pour fournir une force à la structure de came (510).

10. Dispositif électronique (200) de la revendication 9, dans lequel l'élément élastique (520) comprend un premier ressort (521) entourant au moins une partie du premier arbre de poulie (410) et un second ressort (522) entourant au moins une partie du second arbre de poulie (420).

11. Dispositif électronique (200) de l'une quelconque des revendications précédentes, dans lequel le premier arbre de poulie (410) est configuré pour tourner autour d'un premier axe de verrouillage (Ax1),
dans lequel le deuxième arbre de poulie (420) est configuré pour tourner autour d'un deuxième axe de verrouillage (Ax2),
dans lequel la poulie de renvoi (430) est configurée pour tourner autour d'un troisième axe de verrouillage (Ax3), et
dans lequel, lorsque le dispositif électronique (200) est dans un état déplié, une distance entre le troisième axe de verrouillage (Ax3) et l'affichage flexible (230) est supérieure à une distance entre le premier axe de verrouillage (Ax1) et l'affichage flexible (230) ou à une distance entre le second axe de verrouillage (Ax2) et l'affichage flexible (230).

12. Dispositif électronique (200) de l'une quelconque des revendications précédentes, dans lequel la poulie de renvoi (430) comprend une vis d'ajustement de tension (434) configurée pour ajuster une position d'au moins une partie de la poulie de tension (430) lorsque la vis de réglage de tension (434) relie l'arbre de renvoi (431) au support de rotation (330).

13. Dispositif électronique (200) de l'une quelconque des revendications précédentes, dans lequel le fil (440) comprend un toron comprenant une pluralité de fils et un noyau entouré par le toron.

14. Dispositif électronique (200) de l'une quelconque des revendications précédentes, dans lequel le fil (440) comprend de l'acier inoxydable.

15. Dispositif électronique (200) de l'une quelconque des revendications précédentes, dans lequel l'affichage flexible (230) comprend une première zone d'affichage (231) reliée au premier boîtier (210), une deuxième zone d'affichage (232) reliée au deuxième boîtier (220), et une zone de pliage (233) située entre la première zone d'affichage (231) et la deuxième zone d'affichage (232), et
dans lequel au moins une partie de la zone de pliage (233) fait face à la poulie de renvoi (430).
